# EUROPEAN PATENT APPLICATION

(11) **EP 4 583 657 A1**
(43) Date of publication of application: **09.07.2025**
(21) Application number: 24790087.1
(22) Date of filing: 24.04.2024
(51) Int. Cl.: H10B 12/00

(54) **SEMICONDUCTOR STRUCTURE AND PREPARATION METHOD THEREFOR**

(30) Priority: 17.11.2023 CN 202311549929
(71) Applicant: CXMT Corporation, Hefei, Anhui 230601 (CN)
(72) Inventor: LI, Xiaojie, Hefei, Anhui 230601 (CN)
(74) Representative: Gulde & Partner
(86) International application number: PCT/CN2024/089502
(87) International publication number: WO 2025/102608

(57) **Abstract**

A semiconductor structure and a manufacturing method therefor are provided. The semiconductor structure includes: a base; a patterned stacked structure located on the base, including a first dielectric layer and a first conductive layer that are alternately stacked; and a staircase structure located on the base, including multiple stair layer groups that are stacked, where the multiple stair layer groups form multiple stairs distributed in a second direction, the stair layer group includes a second dielectric layer, a second conductive layer, and a third dielectric layer, in the same stair layer group, the third dielectric layer and the second conductive layer are arranged in the second direction and orthographic projections of the third dielectric layer and the second conductive layer on the base overlap an orthographic projection of the second dielectric layer on the base, and the multiple second conductive layers in the multiple stair layer groups have the same orthographic projection area on the base.

## Description

This application claims priority to Chinese Patent Application No. 202311549929.5, filed with the China National Intellectual Property Administration on November 17, 2023 and entitled "SEMICONDUCTOR STRUCTURE AND MANUFACTURING METHOD THEREFOR", which is incorporated herein by reference in its entirety.

### TECHNICAL FIELD

The present disclosure relates to the field of integrated circuit technologies, and in particular, to a semiconductor structure and a manufacturing method therefor.

### BACKGROUND

With the development of semiconductor technologies, three-dimensional storage devices appear. In the three-dimensional storage device, signals are usually led out from layers of conductive lines (e.g., bit lines or word lines) in the storage device through a staircase structure.

However, when a signal is led out through a conventional staircase structure, there is a relatively large resistance-capacitance (RC) delay between the layers of conductive lines (e.g., bit lines or word lines) in the storage device as a quantity of stacked layers increases.

### SUMMARY

Based on this, embodiments of the present disclosure provide a semiconductor structure and a manufacturing method therefor, to effectively reduce an RC delay between layers of conductive lines (e.g., bit lines or word lines).

A semiconductor structure includes:
a base;
a patterned stacked structure located on the base, including a first dielectric layer and a first conductive layer that are alternately stacked and whose orthographic projections on the base overlap each other, where the first conductive layer includes a line connection portion and a first conductive line, and the first conductive line is connected to the line connection portion in a first direction; and
a staircase structure located on the base and located on a side that is of the line connection portion and that is away from the first conductive line in the first direction, including multiple stair layer groups that are stacked, where the multiple stair layer groups form multiple stairs distributed in a second direction, each of the stair layer groups includes a second dielectric layer, a second conductive layer, and a third dielectric layer, the second conductive layer is connected to the line connection portion in the first direction, in the same one of the stair layer groups, the third dielectric layer and the second conductive layer are arranged in the second direction and orthographic projections of the third dielectric layer and the second conductive layer on the base overlap an orthographic projection of the second dielectric layer on the base, the multiple second conductive layers in the multiple stair layer groups have the same orthographic projection area on the base, and the second direction intersects the first direction.

In an embodiment, in the same one of the stair layer groups, the second dielectric layer is away from the base relative to the second conductive layer and the third dielectric layer.

In an embodiment, the staircase structure has a first staircase region, a non-staircase region, and a second staircase region, the first staircase region and the second staircase region are located on two sides of the non-staircase region in the second direction, the multiple stair layer groups form the multiple stairs in both the first staircase region and the second staircase region, and in the same one of the stair layer groups, the second conductive layer is disposed in the first staircase region and/or the second staircase region.

In an embodiment, in the same one of the stair layer groups, the second conductive layer is located on each of two sides of the third dielectric layer in the second direction.

In an embodiment, in the same one of the stair layer groups, the second conductive layer is located only on one side of the third dielectric layer in the second direction, and in a direction perpendicular to the base, the second conductive layers in neighboring stair layer groups are located on two opposite sides in the second direction.

In an embodiment, the semiconductor structure further includes multiple conductive plugs, the multiple conductive plugs respectively run through the multiple stairs to be connected to the corresponding second conductive layers, each of the conductive plugs that runs through an odd-numbered stair is located in the first staircase region, and each of the conductive plugs that runs through an even-numbered stair is located in the second staircase region.

In an embodiment, the multiple second conductive layers in the multiple stair layer groups are completely staggered sequentially in the second direction.

In an embodiment, the multiple second conductive layers in the multiple stair layer groups are partially staggered sequentially in the second direction.

In an embodiment, the line connection portion is disposed on each of both sides of the first conductive line in the first direction, and the staircase structure is disposed on each of both sides of the patterned stacked structure in the first direction.

A manufacturing method for a semiconductor structure includes the steps as follows.

A base is provided.

A patterned stacked structure is formed on the base, where the patterned stacked structure includes a first dielectric layer and a first conductive layer that are alternately stacked and whose orthographic projections on the base overlap each other, the first conductive layer includes a line connection portion and a first conductive line, and the first conductive line is connected to the line connection portion in a first direction.

A staircase structure is formed on the base on a side that is of the line connection portion and that is away from the first conductive line in the first direction, where the staircase structure includes multiple stair layer groups that are stacked, the multiple stair layer groups form multiple stairs distributed in a second direction, each of the stair layer groups includes a second dielectric layer, a second conductive layer, and a third dielectric layer, the second conductive layer is connected to the line connection portion in the first direction, in the same one of the stair layer groups, the third dielectric layer and the second conductive layer are arranged in the second direction and orthographic projections of the third dielectric layer and the second conductive layer on the base overlap an orthographic projection of the second dielectric layer on the base, the multiple second conductive layers in the multiple stair layer groups have the same orthographic projection area on the base, and the second direction intersects the first direction.

In an embodiment, that a patterned stacked structure is formed on the base includes the steps as follows.

A first dielectric material layer and a sacrificial material layer that are alternately stacked are formed on the base.

Patterning processing is performed on the first dielectric material layer and the sacrificial material layer, where the remaining first dielectric material layer forms the first dielectric layer, and the remaining sacrificial material layer forms a sacrificial layer.

The sacrificial layer is removed, and the first conductive layer is formed in a region from which the sacrificial layer is removed.

In an embodiment, the material of the first dielectric material layer includes silicon oxide, and the material of the sacrificial material layer includes silicon nitride.

In an embodiment, that a staircase structure is formed on the base on a side that is of the line connection portion and that is away from the first conductive line in the first direction includes the steps as follows.

An initial staircase structure is formed on the base on the side that is of the line connection portion and that is away from the first conductive line in the first direction, where the initial staircase structure includes multiple initial stair layer groups that are stacked, widths of the multiple initial stair layer groups in the second direction sequentially decrease with a stacking height to form multiple stairs distributed in the second direction, each of the initial stair layer groups includes a third initial dielectric layer and the second dielectric layer formed sequentially, and in the same one of the initial stair layer groups, an orthographic projection of the third initial dielectric layer on the base overlaps an orthographic projection of the second dielectric layer on the base.

The third initial dielectric layer is laterally etched to form a hollow region, where the remaining third initial dielectric layer forms the third dielectric layer.

The second conductive layer is formed in the hollow region.

In an embodiment, that an initial staircase structure is formed on the base on the side that is of the line connection portion and that is away from the first conductive line in the first direction includes the steps as follows.

A second dielectric material layer and a third dielectric material layer that are alternately stacked are formed on the base.

The second dielectric material layer and the third dielectric material layer are etched to form the initial staircase structure, where the third dielectric material layer remaining after etching forms the third initial dielectric layer, and the second dielectric material layer remaining after etching forms the second dielectric layer.

In an embodiment, the material of the second dielectric material layer includes silicon oxide, and the material of the third dielectric material layer includes silicon nitride.

In an embodiment, after the staircase structure is formed on the base on the side that is of the line connection portion and that is away from the first conductive line the in the first direction, the method includes the steps as follows.

Multiple contact holes respectively running through the multiple stairs are formed.

A conductive plug is formed in each of the contact holes, where the conductive plug on each of the stairs is connected to the second conductive layer corresponding to the stair.

In an embodiment, the staircase structure has a first staircase region, a non-staircase region, and a second staircase region, the first staircase region and the second staircase region are located on two sides of the non-staircase region in the second direction, the multiple stair layer groups form the multiple stairs in both the first staircase region and the second staircase region, and in the same one of the stair layer groups, the second conductive layer is disposed in the first staircase region and/or the second staircase region.

In an embodiment, the conductive plugs respectively run through the multiple stairs to be connected to the corresponding second conductive layers, each of the conductive plugs that runs through an odd-numbered stair is located in the first staircase region, and each of the conductive plugs that runs through an even-numbered stair is located in the second staircase region.

In an embodiment, the multiple second conductive layers in the multiple stair layer groups are completely staggered sequentially in the second direction.

In an embodiment, the multiple second conductive layers in the multiple stair layer groups are partially staggered sequentially in the second direction.

In an embodiment, the line connection portion is disposed on each of both sides of the first conductive line in the first direction, and the staircase structure is disposed on each of both sides of the patterned stacked structure in the first direction.

According to the foregoing semiconductor structure and manufacturing method therefor, layers of first conductive lines in a storage device all are connected to the second conductive layers with the same area through the corresponding line connection portions, so that a signal is led out through the second conductive layers with the same area, and an RC delay between the layers of first conductive lines can be effectively reduced. In addition, the multiple stairs are distributed in the second direction, so that the area of the staircase structure can be effectively reduced, which helps improve storage density.

### BRIEF DESCRIPTION OF DRAWINGS

To describe the technical solutions in the embodiments of the present disclosure or the conventional technologies more clearly, the following briefly describes the accompanying drawings required for describing the embodiments or the conventional technologies. Clearly, the accompanying drawings in the following description show merely some embodiments of the present disclosure, and a person of ordinary skill in the art may still derive other drawings from these accompanying drawings without creative efforts.
FIG. 1 is a schematic diagram of a three-dimensional structure of a semiconductor structure according to an embodiment;
FIG. 2(a) is a schematic diagram of a related top-view structure of a first conductive layer and a second conductive layer according to an embodiment;
FIG. 2(b) is a schematic diagram of a top-view structure of a first dielectric layer according to an embodiment;
FIG. 3 is a schematic diagram of a three-dimensional structure of a semiconductor structure according to another embodiment;
FIG. 4 is a flowchart of a manufacturing method for a semiconductor structure according to an embodiment;
FIG. 5 is a schematic diagram of a three-dimensional structure of a structure obtained after a first dielectric material layer and a sacrificial material layer that are alternately stacked are formed in a manufacturing method for a semiconductor structure according to an embodiment;
FIG. 6(a) is a schematic diagram of a top-view structure of a first dielectric layer obtained after patterning processing is performed on a first dielectric material layer and a sacrificial material layer in a manufacturing method for a semiconductor structure according to an embodiment;
FIG. 6(b) is a schematic diagram of a top-view structure of a sacrificial layer obtained after patterning processing is performed on a first dielectric material layer and a sacrificial material layer in a manufacturing method for a semiconductor structure according to an embodiment;
FIG. 7 is a schematic diagram of a three-dimensional structure of a region B in FIG. 6(a) and FIG. 6(b);
FIG. 8 is a schematic diagram of a three-dimensional structure of a structure obtained after a sacrificial layer is removed from FIG. 7;
FIG. 9 is a schematic diagram of a three-dimensional structure of a structure obtained after a first conductive layer is formed in FIG. 8;
FIG. 10 is a schematic diagram of a local three-dimensional structure obtained after an initial staircase structure is formed in a manufacturing method for a semiconductor structure according to an embodiment;
FIG. 11 is a schematic diagram of a local three-dimensional structure obtained after a hollow region is formed in a manufacturing method for a semiconductor structure according to an embodiment;
FIG. 12 is a schematic diagram of a local three-dimensional structure obtained after a second conductive layer is formed in a manufacturing method for a semiconductor structure according to an embodiment;
FIG. 13 is a schematic diagram of a related top-view structure of a first conductive layer and a second conductive layer obtained after contact holes are formed in a manufacturing method for a semiconductor structure according to an embodiment;
FIG. 14 is a schematic diagram of a local three-dimensional structure obtained after conductive plugs are formed in a manufacturing method for a semiconductor structure according to an embodiment; and
FIG. 15 is a schematic diagram of a three-dimensional structure of a semiconductor structure according to still another embodiment.

Descriptions of reference numerals:
100-base; 200-patterned stacked structure; 210-first dielectric layer; 2101-first dielectric material layer; 220-first conductive layer; 221-line connection portion; 222-first conductive line; 230-sacrificial layer; 2301-sacrificial material layer; 300-staircase structure; 3001-initial staircase structure; 310-stair layer group; 3101-initial stair layer group; 311-second dielectric layer; 312-second conductive layer; 313-third dielectric layer; 3131-third initial dielectric layer; 400-conductive plug; 500-storage array; 10-contact hole; and 20-conductive line hole.

### DESCRIPTION OF EMBODIMENTS

For ease of understanding of the present disclosure, a more comprehensive description of the present disclosure is provided below with reference to related accompanying drawings. A preferred embodiment of the present disclosure is provided in the accompanying drawings. However, the present disclosure may be implemented in many different forms, and is not limited to the embodiments described in this specification. Instead, the purpose of providing these embodiments is to make the content of the present disclosure more thorough and comprehensive.

Unless otherwise defined, all technical and scientific terms utilized in this specification have meanings the same as those commonly understood by a person skilled in the technical field of the present disclosure. The terms utilized in the specification of the present disclosure are merely intended to describe specific embodiments, and are not intended to limit the present disclosure.

It should be understood that, an element or a layer may be directly on, adjacent to, connected to, or coupled to another element or layer or there may be an intermediate element or layer when the element or the layer is referred to as "on", "adjacent to", "connected to", or "coupled to" the another element or layer. Instead, there is no intermediate element or layer when an element is referred to as "directly on", "directly adjacent to", "directly connected to", or "directly coupled to" another element or layer. It should be understood that, although the terms "first", "second", "third", and the like may be adopted to describe various elements, components, regions, layers, doping types, and/or portions, these elements, components, regions, layers, doping types, and/or portions shall not be limited by these terms. These terms are merely utilized to distinguish one element, component, region, layer, doping type, or portion from another element, component, region, layer, doping type, or portion. Therefore, a first element, component, region, layer, doping type, or portion discussed below may be represented as a second element, component, region, layer, or portion without departing from the teachings of the present disclosure. For example, a first doping type may be referred to as a second doping type, and similarly, a second doping type may be referred to as a first doping type. The first doping type and the second doping type are different doping types. For example, the first doping type may be a P-type and the second doping type may be an N-type, or the first doping type may be an N-type and the second doping type may be a P-type.

Spatial relationship terms, e.g., "under", "below", "underlying", "beneath", "over", "above", and the like may be utilized herein to describe a relationship between one element or feature shown in the figures and another component or feature. It should be understood that in addition to the orientations shown in the figures, the spatial relationship terms further include different orientations of devices in use and operation. An element or a feature described as "below another element" is oriented to be "above" the another element or feature, e.g., if the devices in the accompanying drawings are flipped. Therefore, the example term "below" may include orientations of being above and being below. In addition, the devices may alternatively be otherwise oriented (rotated by 90 degrees or oriented in another manner), and the spatial descriptors utilized herein are interpreted accordingly.

As utilized herein, the singular forms of "a", "an", and "the" may also intended to include plural forms unless otherwise clearly specified in the context. It should also be understood that, the presence of the feature, integer, step, operation, element, and/or component can be determined without ruling out the presence or addition of one or more other features, integers, steps, operations, elements, components, and/or groups when the term "constitute" and/or the term "include" are/is utilized in the specification. Moreover, as utilized herein, the term "and/or" includes any and all combinations of the related items listed.

As described in the background, when a signal is led out through a conventional staircase structure, there is a relatively large RC delay between layers of conductive lines (e.g., bit lines or word lines) in a storage device as a quantity of stacked layers increases.

Based on this, embodiments of the present disclosure provide a semiconductor structure and a manufacturing method for a semiconductor structure. The semiconductor structure may, but is not limited to, be formed with the manufacturing method for a semiconductor structure in the following embodiments. In addition, the semiconductor structure and the manufacturing method for a semiconductor structure provided in the embodiments of the present disclosure may, but are not limited to, be applied to manufacturing of a three-dimensional dynamic random access memory (DRAM) device.

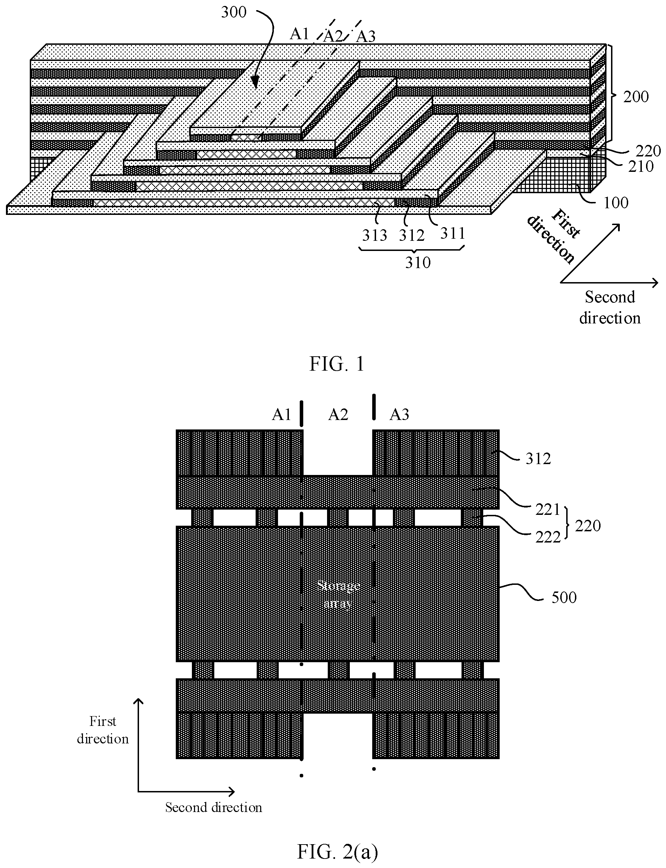

In an embodiment, referring to FIG. 1, a semiconductor structure is provided. The semiconductor structure includes a base 100, a patterned stacked structure 200, and a staircase structure 300. The patterned stacked structure 200 and the staircase structure 300 are located in different regions on the base 100.

It should be noted that in FIG. 1, to make the accompanying drawing clear, the base 100 below the staircase structure 300 is not illustrated. However, actually, the staircase structure 300 is also formed on the base 100.

The base 100 may include a substrate. The substrate may include a silicon (Si) substrate, a silicon germanium (SiGe) substrate, a silicon germanium carbon (SiGeC) substrate, a silicon carbide (SiC) substrate, a gallium arsenide (GaAs) substrate, an indium arsenide (InAs) substrate, an indium phosphide (InP) substrate, or another III/V semiconductor substrate or II/VI semiconductor substrate. Alternatively, for another example, the substrate may also include substrates such as Si/SiGe, Si/SiC, silicon on insulator (SOI), or silicon germanium on insulator. Therefore, the type of the substrate shall not limit the protection scope of the present disclosure.

In an example, the base 100 may further include a peripheral circuit structure (not shown in the figure), and the peripheral circuit structure may be formed based on the semiconductor substrate. Certainly, the peripheral circuit structure is located on a side that is of the staircase structure 300 and that is away from the base 100. This is not limited herein.

The patterned stacked structure 200 includes a first dielectric layer 210 and a first conductive layer 220 that are alternately stacked. The bottom layer of the patterned stacked structure may be the first dielectric layer 210, or may be the first conductive layer 220. In addition, the top layer of the patterned stacked structure may be the first dielectric layer 210, or may be the first conductive layer 220.

Referring to FIG. 2(a), the first conductive layer 220 includes a line connection portion 221 and a first conductive line 222, and the first conductive line 222 is connected to the line connection portion 221 in a first direction.

The material of the first conductive layer 220 may include but is not limited to cobalt (Co), nickel (Ni), titanium (Ti), tungsten (W), tantalum (Ta), tantalum titanium (TaTi), tungsten nitride (WN), copper (Cu), aluminum (Al), and the like.

In an example, the first conductive line 222 may be a bit line or a word line of a storage unit. The first conductive layer 220 may include multiple first conductive lines 222. The multiple first conductive lines 222 may be arranged in a second direction. The second direction intersects the first direction. For example, the second direction may be perpendicular to the first direction. In addition, on the same side in the first direction, multiple first conductive lines 222 may be connected to the same line connection portion 221.

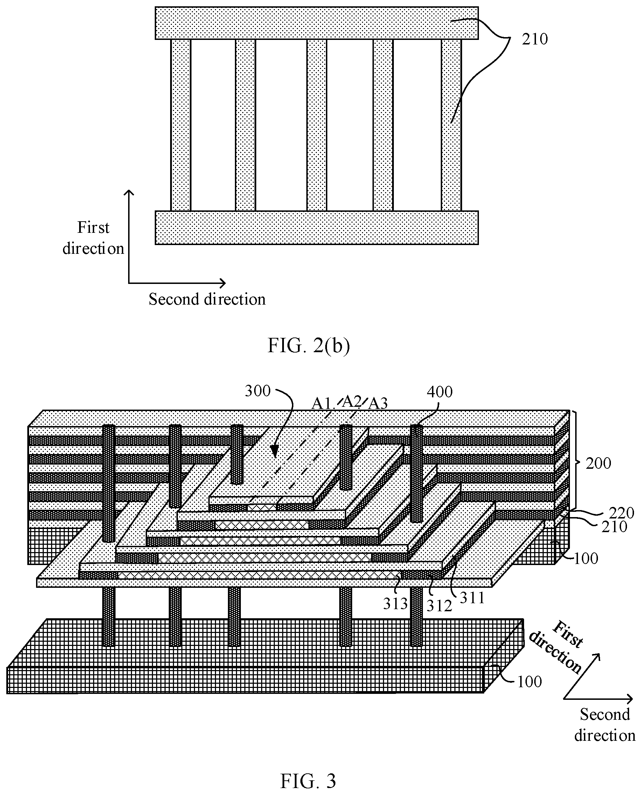

Referring to FIG. 2(b), the first dielectric layer 210 and the first conductive layer 220 are alternately stacked. Shapes of the first dielectric layer and the first conductive layer are the same, and orthographic projections of the first dielectric layer and the first conductive layer on the base 100 overlap each other.

It may be understood that, "orthographic projection overlapping" mentioned in this specification means that contours of orthographic projections are consistent and overlap each other. Moreover, "orthographic projection overlapping" is overlapping in a broad sense that allows specific process errors in actual processes.

The material of the first dielectric layer 210 includes but is not limited to a silicon oxide (SiO₂), a silicon nitride (Si₃N₄), aluminum oxide (Al₂O₃), or a silicon oxynitride (SiON).

In addition, an opening region of the patterned stacked structure 200 may be filled with a fourth dielectric layer (not shown in the figure), and a storage unit (for example, including a transistor or a capacitor) located at the fourth dielectric layer may be disposed in the opening region. The storage unit may be connected to the first conductive line 222. In addition, multiple storage units may be arranged in an array to form a storage array 500, referring to FIG. 2(a). To make the accompanying drawing clear, in FIG. 2(a), the storage array 500 is illustrated in a form of a block diagram.

Referring to FIG. 1 and FIG. 2(a), the staircase structure 300 is located on a side that is of the line connection portion 221 and that is away from the first conductive line 222 in the first direction. In other words, the staircase structure 300 and the first conductive line 222 are respectively disposed on two opposite sides of the line connection portion 221 in the first direction.

Referring to FIG. 1, the staircase structure 300 includes multiple stair layer groups 310 that are stacked. In addition, the multiple stair layer groups 310 that are stacked form multiple stairs distributed in the second direction.

Each stair layer group 310 includes a second dielectric layer 311, a second conductive layer 312, and a third dielectric layer 313.

In the same stair layer group 310, the third dielectric layer 313 and the second conductive layer 312 are arranged in the second direction. Therefore, the third dielectric layer and the second conductive layer are located in the same film layer position.

In an example, in the same stair layer group 310, the second dielectric layer 311 may be away from the base 100 relative to the second conductive layer 312 and the third dielectric layer 313. In this case, both the third dielectric layer 313 and the second conductive layer 312 may be located at a lower layer in the stair layer group 310, and the second dielectric layer 311 may be located at an upper layer in the stair layer group 310.

Alternatively, in the same stair layer group 310, the second dielectric layer 311 may be close to the base 100 relative to the second conductive layer 312 and the third dielectric layer 313. In this case, both the third dielectric layer 313 and the second conductive layer 312 may be located at an upper layer in the stair layer group 310, and the second dielectric layer 311 may be located at a lower layer in the stair layer group 310.

In addition, in the same stair layer group 310, orthographic projections of the third dielectric layer 313 and the second conductive layer 312 on the base 100 overlap an orthographic projection of the second dielectric layer 311 on the base 100.

Referring to FIG. 1 and FIG. 2(a), the second conductive layer 312 is connected to the line connection portion 221 in the first direction, to be electrically connected to the first conductive line 222 through the line connection portion 221. Projections of the multiple second conductive layers 312 in the multiple stair layer groups 310 on the base 100 may be at least partially staggered in the second direction, so that a signal is led out from the first conductive line 222 through the second conductive layers 312, and parasitic capacitance between the second conductive layers 312 can be effectively reduced.

In an example, the projections of the multiple second conductive layers 312 in the multiple stair layer groups 310 on the base 100 may be completely staggered sequentially in the second direction; or the projections of the multiple second conductive layers 312 in the multiple stair layer groups 310 on the base 100 may be partially staggered sequentially in the second direction.

The material of the second conductive layer 312 may include but is not limited to cobalt (Co), nickel (Ni), titanium (Ti), tungsten (W), tantalum (Ta), tantalum titanium (TaTi), tungsten nitride (WN), copper (Cu), aluminum (Al), and the like. The material of the second conductive layer 312 is the same as the material of the first conductive layer 220, or may be different from the material of the first conductive layer 220. This is not limited herein.

In addition, in the first direction, the third dielectric layer 313 may also be connected to the line connection portion 221, and the second dielectric layer 311 may be connected to the first dielectric layer 210. In addition, thicknesses of the third dielectric layer 313 and the second conductive layer 312 may be the same as the thickness of the first conductive layer 220, and the thickness of the second dielectric layer 311 may be the same as the thickness of the first dielectric layer 210.

The material of the third dielectric layer 313 and/or the material of the second dielectric layer 311 may include but is not limited to a silicon oxide (SiO₂), a silicon nitride (Si₃N₄), aluminum oxide (Al₂O₃), or a silicon oxynitride (SiON). In an example, it may be set that the material of the second dielectric layer 311 is the same as the material of the first dielectric layer 210 and different from the material of the third dielectric layer 313. For example, it may be set that the material of the second dielectric layer 311 and the material of the first dielectric layer 210 are silicon oxide, and the material of the third dielectric layer 313 is silicon nitride.

In addition, the multiple second conductive layers 312 in the multiple stair layer groups 310 have the same orthographic projection area on the base 100, that is, areas of the second conductive layers 312 are the same.

In this embodiment, the multiple stair layer groups 310 are disposed to form the multiple stairs distributed in the second direction. The distribution direction of the stairs is disposed in another direction that intersects the first direction rather than in the first direction (the connection direction of the second conductive layer 312 and the first conductive layer 220). Therefore, the length of the second conductive layer 312 in the first direction may not increase as the quantity of stacked layers increases. In addition, the third dielectric layer 313 located in the same film layer position as the second conductive layer 312 is disposed in each stair layer group 310, and the third dielectric layer 313 and the second conductive layer 312 are arranged in the second direction. Therefore, the length of the second conductive layer 312 in the second direction may not increase as the quantity of stacked layers increases either, and the areas of the second conductive layers 312 may be set to be the same. In addition, the second conductive layer 312 is disposed to be connected to the line connection portion 221 in the first direction. In this case, the first conductive line 222 may be electrically connected to the second conductive layer 312 effectively through the line connection portion 221.

In this case, layers of first conductive lines 222 in a storage device all are connected to the second conductive layers 312 with the same area through the corresponding line connection portions 221, so that a signal is led out through the second conductive layers 312 with the same area, and an RC delay between the layers of first conductive lines 222 can be effectively reduced.

In addition, in this embodiment, the multiple stairs are distributed in the second direction, so that the area of the staircase structure 300 can be effectively reduced, which helps improve storage density.

In an embodiment, referring to FIG. 1, the staircase structure 300 has a first staircase region A1, a non-staircase region A2, and a second staircase region A3. The first staircase region A1, the non-staircase region A2, and the second staircase region A3 may be sequentially arranged in the second direction, that is, the first staircase region A1 and the second staircase region A3 are located on two sides of the non-staircase region A2 in the second direction.

The multiple stair layer groups 310 form the multiple stairs in both the first staircase region A1 and the second staircase region A3. In the same stair layer group 310, the second conductive layer 312 may be disposed in the first staircase region A1 and/or the second staircase region A3.

In this case, signals may be respectively led out from different layers of first conductive lines 222 (bit lines or word lines) through the second conductive layers 312 located in the first staircase region A1 and the second staircase region A3, thereby reducing signal interference between different layers of first conductive lines 222.

In an embodiment, referring to FIG. 1, when the multiple stair layer groups 310 form the multiple stairs in both the first staircase region A1 and the second staircase region A3, in the same stair layer group 310, the second conductive layer 312 is located on each of two sides of the third dielectric layer 313 in the second direction.

For each stair layer group 310, the second conductive layers 312 may be symmetrically disposed on both sides of the third dielectric layer 313 in the second direction. In each stair layer group 310, the second conductive layers 312 located on the two sides of the third dielectric layer 313 in the second direction may be respectively located in stair positions in the first staircase region A1 and the second staircase region A3. In this case, it is convenient to process and manufacture the stair layer group 310.

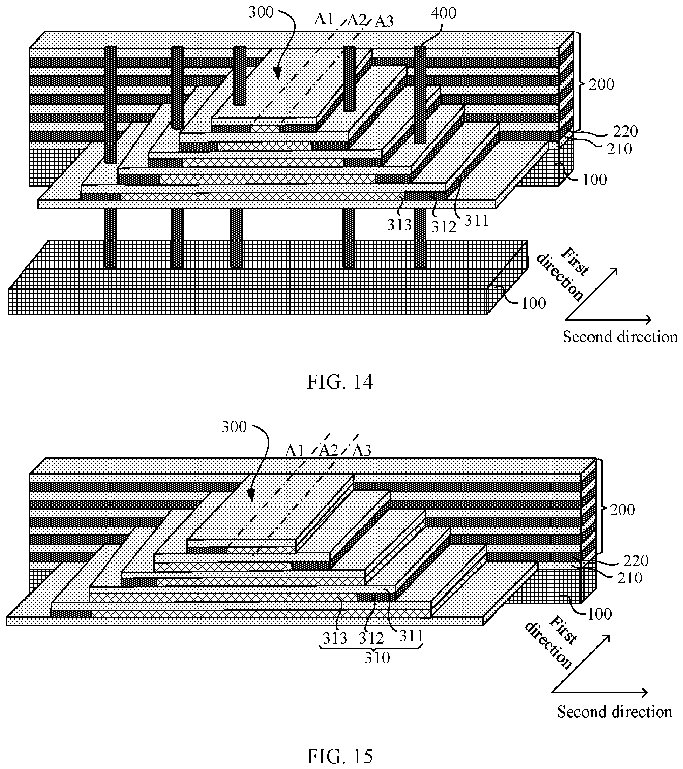

Certainly, in another embodiment, disposing forms of the second conductive layer 312 and the third dielectric layer 313 in the stair layer group 310 are not limited thereto. For example, referring to FIG. 15, in the same stair layer group 310, the second conductive layer 312 is located only on one side of the third dielectric layer 313 in the second direction. In the direction perpendicular to the base 100, the second conductive layers 312 in neighboring stair layer groups 310 are located on two opposite sides in the second direction. In this case, in neighboring stair layer groups 310 in the direction perpendicular to the base 100, the second conductive layers 312 may be separately disposed in the first staircase region A1 and the second staircase region A3.

In an embodiment, referring to FIG. 3, the semiconductor structure further includes multiple conductive plugs 400, and the multiple conductive plugs 400 respectively run through the multiple stairs to be connected to the corresponding second conductive layers 312. In addition, the conductive plugs 400 may extend into a peripheral circuit structure located in the base 100, so that the conductive plugs 400 are electrically connected to the peripheral circuit structure. It should be noted that in FIG. 3, to make the figure clear, the base 100 below the staircase structure 300 is moved downward. However, in an actual structure, the base 100 below the staircase structure 300 and the base 100 below the patterned stacked structure 200 are the same base.

Certainly, a peripheral circuit structure may be disposed on the top of the conductive plugs 400, so that the conductive plugs 400 are electrically connected to the peripheral circuit structure.

When the multiple conductive plugs 400 respectively run through the multiple stairs to be connected to the corresponding second conductive layers 312, the conductive plugs 400 may run through the second conductive layers 312 at the stairs to be connected to the second conductive layers. Certainly, a connection form between the conductive plug 400 and the second conductive layer 312 is not limited thereto. For example, in some embodiments, the third dielectric layer 313 (not shown in the figure) may be disposed on each of both sides of the second conductive layer 312 in the second direction. In this case, the conductive plug 400 may alternatively run through the third dielectric layer 313 to be connected to the second conductive layer 312 in the second direction. Alternatively, the conductive plug 400 may run through both the third dielectric layer 313 and the second conductive layer 312.

In addition, the multiple stair layer groups 310 are disposed to form the multiple stairs in both the first staircase region A1 and the second staircase region A3. The conductive plug 400 running through an odd-numbered stair is located in the first staircase region A1, and the conductive plug 400 running through an even-numbered stair is located in the second staircase region A3.

In this case, the conductive plugs 400 for leading signals out from different layers of first conductive lines 222 (bit lines or word lines) may be respectively disposed in the first staircase region A1 and the second staircase region A3, to reduce arrangement density of the conductive plugs 400, thereby effectively preventing a short-circuit risk between the conductive plugs 400.

In an embodiment, referring to FIG. 1 and FIG. 2(a), the line connection portion 221 is disposed on each of both sides of the first conductive line 222 in the first direction, and the staircase structure 300 is disposed on each of both sides of the patterned stacked structure 200 in the first direction.

In this case, in an example, referring to FIG. 2(a), the semiconductor structure may include two line connection portions 221 extending in the second direction. In addition, the two line connection portions 221 are disposed opposite to each other in the first direction.

Multiple first conductive lines 222 (e.g., bit lines or word lines) arranged in the second direction are disposed between the two line connection portions 221. Each first conductive line 222 is disposed to be connected to two line connection portions 221 located on both sides of the first conductive line in the first direction.

In this case, different layers of first conductive lines 222 (bit lines or word lines) may be respectively connected to second conductive layers 312 in different staircase structures 300 through different line connection portions 221, to lead out signals, thereby reducing signal interference between different layers of first conductive lines 222. In addition, the conductive plugs 400 disposed at the second conductive layers 312 may be distributed on the staircase structure 300 located on each of two sides of the patterned stacked structure 200 in the first direction, to reduce arrangement density of the conductive plugs 400, thereby effectively preventing a short-circuit risk between the conductive plugs 400.

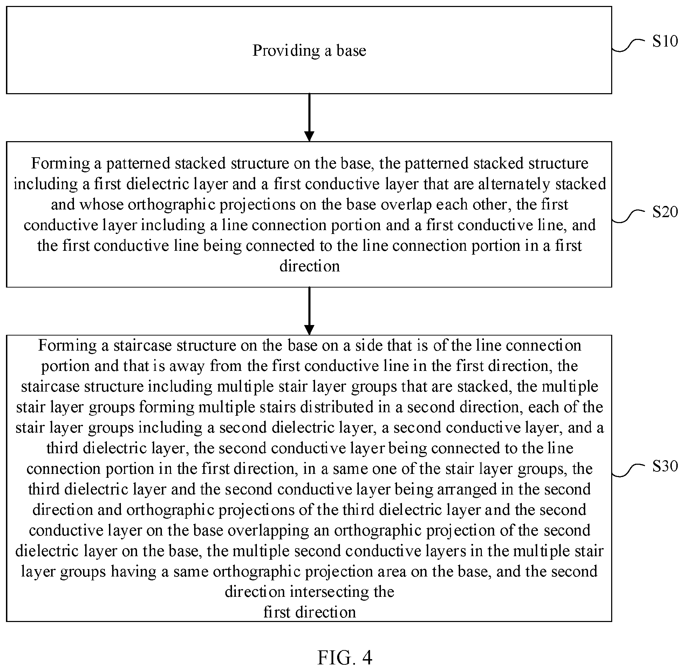

In an embodiment, referring to FIG. 4, a manufacturing method for a semiconductor structure is further provided, including the steps as follows.

In the step of S10, a base 100 is provided.

In the step of S20, a patterned stacked structure 200 is formed on the base 100, where the patterned stacked structure 200 includes a first dielectric layer 210 and a first conductive layer 220 that are alternately stacked and whose orthographic projections on the base 100 overlap each other, the first conductive layer 220 includes a line connection portion 221 and a first conductive line 222, and the first conductive line 222 is connected to the line connection portion 221 in a first direction.

In the step of S30, a staircase structure 300 is formed on the base 100 on a side that is of the line connection portion 221 and that is away from the first conductive line 222 in the first direction, where the staircase structure 300 includes multiple stair layer groups 310 that are stacked, the multiple stair layer groups 310 form multiple stairs distributed in a second direction, the stair layer group 310 includes a second dielectric layer 311, a second conductive layer 312, and a third dielectric layer 313, the second conductive layer 312 is connected to the line connection portion 221 in the first direction, in the same stair layer group 310, the third dielectric layer 313 and the second conductive layer 312 are arranged in the second direction and orthographic projections of the third dielectric layer and the second conductive layer on the base 100 overlap an orthographic projection of the second dielectric layer 311 on the base 100, the multiple second conductive layers 312 in the multiple stair layer groups 310 have the same orthographic projection area on the base 100, and the second direction intersects the first direction.

In the step of S10, the base 100 may include a substrate. The substrate may include a silicon (Si) substrate, a silicon germanium (SiGe) substrate, a silicon germanium carbon (SiGeC) substrate, a silicon carbide (SiC) substrate, a gallium arsenide (GaAs) substrate, an indium arsenide (InAs) substrate, an indium phosphide (InP) substrate, or another III/V semiconductor substrate or II/VI semiconductor substrate. Alternatively, for another example, the substrate may also include substrates such as Si/SiGe, Si/SiC, silicon on insulator (SOI), or silicon germanium on insulator. Therefore, the type of the substrate shall not limit the protection scope of the present disclosure.

In an example, the base 100 may further include a peripheral circuit structure, and the peripheral circuit structure may be formed based on the semiconductor substrate. Certainly, the peripheral circuit structure may alternatively be formed after the staircase structure 300 is formed. This is not limited herein.

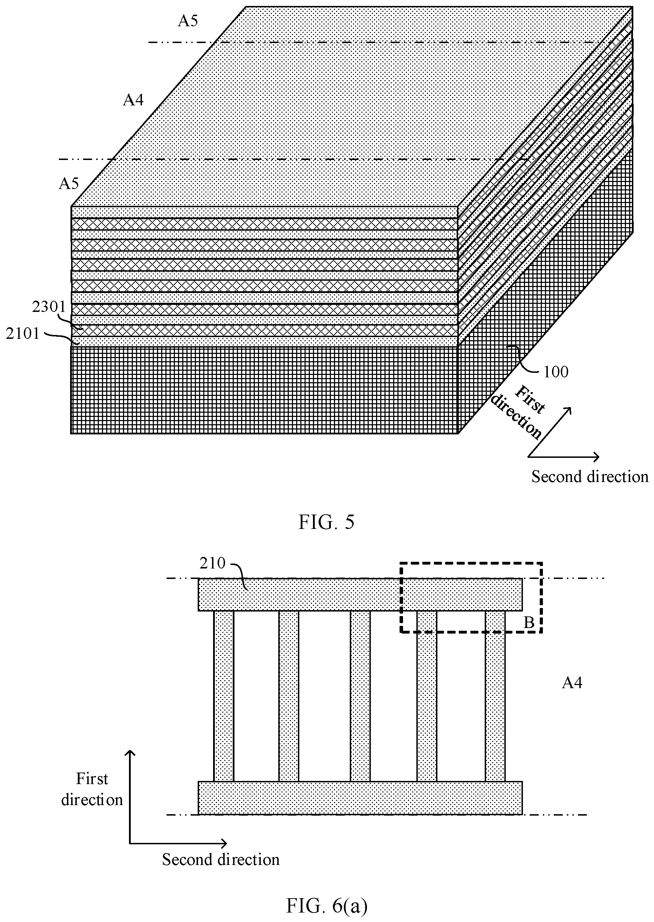

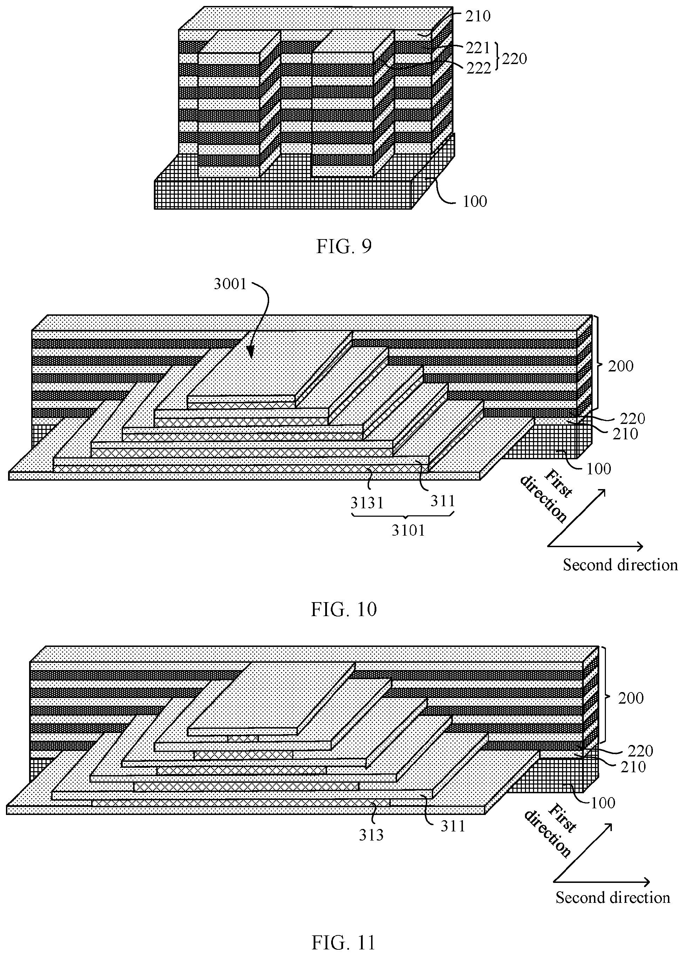

In the step of S20, referring to FIG. 5 and FIG. 9, the patterned stacked structure 200 may be formed in a first region A4 on the base 100, which may be formed with a patterning process. The patterned stacked structure 200 includes the first dielectric layer 210 and the first conductive layer 220. The bottom layer of the patterned stacked structure may be the first dielectric layer 210, or may be the first conductive layer 220. In addition, the top layer of the patterned stacked structure may be the first dielectric layer 210, or may be the first conductive layer 220.

The first dielectric layer 210 and the first conductive layer 220 are alternately stacked. Shapes of the first dielectric layer and the first conductive layer are the same, and orthographic projections of the first dielectric layer and the first conductive layer on the base 100 overlap each other.

It may be understood that, "orthographic projection overlapping" mentioned in this specification means that contours of orthographic projections are consistent and overlap each other. Moreover, "orthographic projection overlapping" is overlapping in a broad sense that allows specific process errors in actual processes.

The material of the first conductive layer 220 may include but is not limited to cobalt (Co), nickel (Ni), titanium (Ti), tungsten (W), tantalum (Ta), tantalum titanium (TaTi), tungsten nitride (WN), copper (Cu), aluminum (Al), and the like.

The first conductive layer 220 includes the line connection portion 221 and the first conductive line 222, and the first conductive line 222 is connected to the line connection portion 221 in the first direction.

In an example, the first conductive line 222 may be a bit line or a word line of a storage unit. The first conductive layer 220 may include multiple first conductive lines 222. The multiple first conductive lines 222 may be arranged in the second direction. The second direction intersects the first direction. For example, the second direction may be perpendicular to the first direction. In addition, on the same side in the first direction, multiple first conductive lines 222 may be connected to the same line connection portion 221.

The material of the first dielectric layer 210 includes but is not limited to a silicon oxide (SiO₂), a silicon nitride (Si₃N₄), aluminum oxide (Aₗ₂O₃), or a silicon oxynitride (SiON).

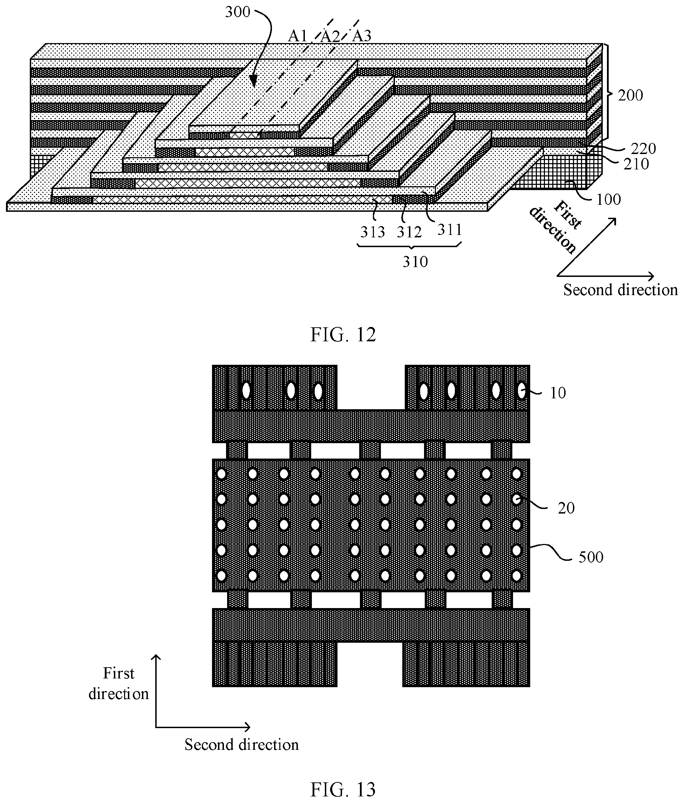

In the step of S30, referring to FIG. 5 and FIG. 12, the staircase structure 300 may be formed in a second region A5 on the base 100. The second region A5 is connected to the first region A4 in the first direction. In an example, the second region A5 is located at an edge of the base 100 in the first direction.

Before the staircase structure 300 is formed, a fourth dielectric layer may be first filled in an opening region of the patterned stacked structure 200 in the first region A4, to flatten the first region A4. The material of the fourth dielectric layer may include but is not limited to a silicon oxide (SiO₂), a silicon nitride (Si₃N₄), aluminum oxide (Al₂O₃), or a silicon oxynitride (SiON).

The fourth dielectric layer may be of a single-layer structure, or may be of a multi-layer structure.

In an example, before the staircase structure 300 is formed, in addition to filling the opening region of the patterned stacked structure 200 with the fourth dielectric layer, storage units (for example, including transistors or capacitors) located at the fourth dielectric layer may be further formed in the opening region. The storage units may be arranged in an array to form a storage array.

The staircase structure 300 is formed after the fourth dielectric layer is filled, so that formation of the staircase structure 300 does not affect a structure in the first region A4.

After the staircase structure 300 is formed, multiple stair layer groups 310 that are stacked are formed. In addition, the multiple stair layer groups 310 that are stacked form multiple stairs distributed in the second direction.

Each stair layer group 310 includes the second dielectric layer 311, the second conductive layer 312, and the third dielectric layer 313.

In the same stair layer group 310, the third dielectric layer 313 and the second conductive layer 312 are arranged in the second direction. Therefore, the third dielectric layer and the second conductive layer are located in the same film layer position.

In an example, in the same stair layer group 310, the second dielectric layer 311 may be away from the base 100 relative to the second conductive layer 312 and the third dielectric layer 313. In this case, both the third dielectric layer 313 and the second conductive layer 312 may be located at a lower layer in the stair layer group 310, and the second dielectric layer 311 may be located at an upper layer in the stair layer group 310.

Alternatively, in the same stair layer group 310, the second dielectric layer 311 may be close to the base 100 relative to the second conductive layer 312 and the third dielectric layer 313. In this case, both the third dielectric layer 313 and the second conductive layer 312 may be located at an upper layer in the stair layer group 310, and the second dielectric layer 311 may be located at a lower layer in the stair layer group 310.

In addition, in the same stair layer group 310, orthographic projections of the third dielectric layer 313 and the second conductive layer 312 on the base 100 overlap an orthographic projection of the second dielectric layer 311 on the base 100.

The second conductive layer 312 is connected to the line connection portion 221 in the first direction, and is further electrically connected to the first conductive line 222 through the line connection portion 221. Projections of the multiple second conductive layers 312 in the multiple stair layer groups 310 on the base 100 may be at least partially staggered in the second direction, so that a signal is led out from the first conductive line 222 through the second conductive layers 312, and parasitic capacitance between the second conductive layers 312 can be effectively reduced.

In an example, the projections of the multiple second conductive layers 312 in the multiple stair layer groups 310 on the base 100 may be completely staggered sequentially in the second direction; or the projections of the multiple second conductive layers 312 in the multiple stair layer groups 310 on the base 100 may be partially staggered sequentially in the second direction.

The material of the second conductive layer 312 may include but is not limited to cobalt (Co), nickel (Ni), titanium (Ti), tungsten (W), tantalum (Ta), tantalum titanium (TaTi), tungsten nitride (WN), copper (Cu), aluminum (Al), and the like. The material of the second conductive layer 312 is the same as the material of the first conductive layer 220, or may be different from the material of the first conductive layer 220. This is not limited herein.

In addition, in the first direction, the third dielectric layer 313 may also be connected to the line connection portion 221, and the second dielectric layer 311 may be connected to the first dielectric layer 210. In addition, thicknesses of the third dielectric layer 313 and the second conductive layer 312 may be the same as the thickness of the first conductive layer 220, and the thickness of the second dielectric layer 311 may be the same as the thickness of the first dielectric layer 210.

The material of the third dielectric layer 313 and/or the material of the second dielectric layer 311 may include but is not limited to a silicon oxide (SiO₂), a silicon nitride (Si₃N₄), aluminum oxide (Al₂O₃), or a silicon oxynitride (SiON). In an example, it may be set that the material of the second dielectric layer 311 is the same as the material of the first dielectric layer 210 and different from the material of the third dielectric layer 313. For example, it may be set that the material of the second dielectric layer 311 and the material of the first dielectric layer 210 are silicon oxide, and the material of the third dielectric layer 313 is silicon nitride.

In addition, the multiple second conductive layers 312 in the multiple stair layer groups 310 have the same orthographic projection area on the base 100, that is, areas of the second conductive layers 312 are the same.

In this embodiment, layers of first conductive line 222 in a storage device all are connected to the second conductive layers 312 with the same area through the corresponding line connection portions 221, so that a signal is led out through the second conductive layers 312 with the same area, and an RC delay between the layers of first conductive lines 222 can be effectively reduced. In addition, the multiple stairs are distributed in the second direction, so that the area of the staircase structure 300 can be effectively reduced, which helps improve storage density.

In an embodiment, the step of S20 includes the steps as follows.

In the step of S21, a first dielectric material layer 2101 and a sacrificial material layer 2301 that are alternately stacked are formed on the base 100, referring to FIG. 5.

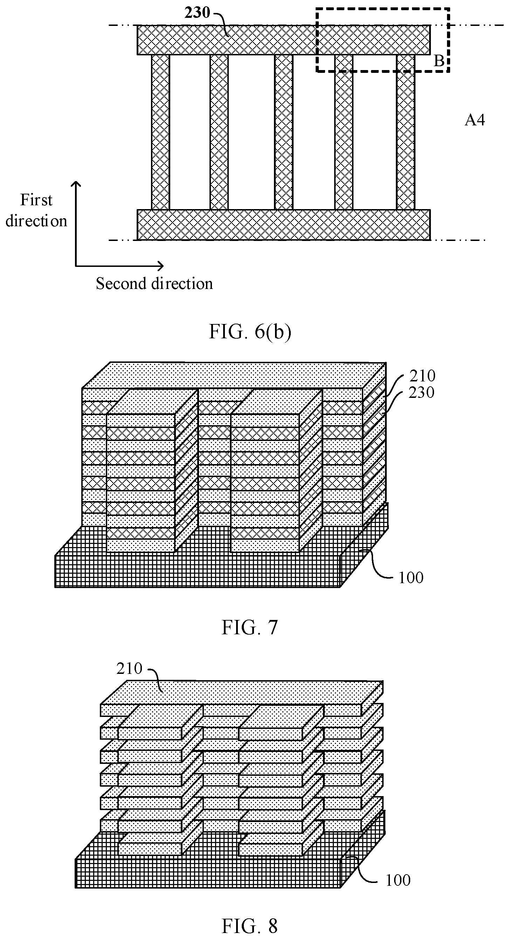

In the step of S22, patterning processing is performed on the first dielectric material layer 2101 and the sacrificial material layer 2301, where the remaining first dielectric material layer 2101 forms the first dielectric layer 210, referring to FIG. 6(a), and the remaining sacrificial material layer 2301 forms a sacrificial layer 230, referring to FIG. 6(b).

In the step of S23, the sacrificial layer 230 is removed, and the first conductive layer 220 is formed in a region from which the sacrificial layer 230 is removed, referring to FIG. 7 to FIG. 9.

In the step of S21, referring to FIG. 5, the first dielectric material layer 2101 and the sacrificial material layer 2301 that are alternately stacked may be sequentially formed on the base 100 with a deposition process. In an example, it may be set that the material of the first dielectric material layer 2101 includes silicon oxide, and the material of the sacrificial material layer 2301 includes silicon nitride.

The deposition process may include but is not limited to one or more of processes such as a Chemical Vapor Deposition (CVD) process, an Atomic Layer Deposition (ALD) process, a High Density Plasma (HDP) Deposition process, a plasma enhanced deposition process, and a Spin-on Dielectric (SOD) process.

In an example, the first dielectric material layer 2101 may be first formed on the surface of the base 100, and then the sacrificial material layer 2301 is formed. Then, the first dielectric material layer 2101 and the sacrificial material layer 2301 are alternately formed repeatedly. In this case, after the first conductive layer 220 is formed in the subsequent step of S23, the first conductive layer 220 may be effectively isolated from the base 100 through the first dielectric layer 210. Certainly, in another example, the sacrificial material layer 2301 may be first formed on the surface of the base 100. This is not limited herein.

In an example, after the first dielectric material layer 2101 and the sacrificial material layer 2301 that are alternately stacked are formed on the base 100, the top layer of stacked layers may be the first dielectric material layer 2101. In this case, after the sacrificial layer 230 is removed in the subsequent step of S23, the first dielectric layer 210 at the top layer may be effectively reserved. Certainly, in another example, after the first dielectric material layer 2101 and the sacrificial material layer 2301 that are alternately stacked are formed on the base 100, the top layer of the stacked layers may alternatively be the sacrificial material layer 2301. This is not limited herein.

In the step of S22, a patterned photoresist may be formed on the first dielectric material layer 2101 and the sacrificial material layer 2301 that are alternately stacked. Then, based on the patterned photoresist, dry etching is performed on the first dielectric material layer 2101 and the sacrificial material layer 2301 that are alternately stacked, to form the first dielectric layer 210 and the sacrificial layer 230, referring to FIG. 6(a) and FIG. 6(b). Further, the patterned photoresist may be removed.

In the step of S23, dry etching may be first performed on the sacrificial layer 230 from a region from which the first dielectric material layer 2101 and the sacrificial material layer 2301 are removed through etching, to remove the sacrificial layer 230, referring to FIG. 7 and FIG. 8.

Then, the first conductive layer 220 may be formed, in a manner such as electroplating or chemical vapor deposition, in the region from which the sacrificial layer 230 is removed, referring to FIG. 9.

In this embodiment, the first dielectric material layer 2101 and the sacrificial material layer 2301 that are alternately stacked are first formed to perform high-quality etching in a process of forming the patterned stacked structure 200, thereby performing high-quality patterning processing. Certainly, in another embodiment, in the process of forming the patterned stacked structure 200, the first dielectric material layer 2101 and a first conductive material layer that are alternately stacked may alternatively be directly formed, and then patterning processing is performed on the first dielectric material layer and the first conductive material layer to form the first dielectric layer 210 and the first conductive layer 220.

In an embodiment, the step of S30 includes the steps as follows.

In the step of S31, referring to FIG. 10, an initial staircase structure 3001 is formed on the base 100 on the side that is of the line connection portion 221 and that is away from the first conductive line 222 in the first direction, where the initial staircase structure 3001 includes multiple initial stair layer groups 3101 that are stacked, widths of the multiple initial stair layer groups 3101 in the second direction sequentially decrease with a stacking height to form multiple stairs distributed in the second direction, and the initial stair layer group 3101 includes a third initial dielectric layer 3131 and a second dielectric layer 311 formed sequentially, and in the same initial stair layer group 3101, an orthographic projection of the third initial dielectric layer 3131 on the base 100 overlaps an orthographic projection of the second dielectric layer 311 on the base 100.

In the step of S32, referring to FIG. 11, the third initial dielectric layer 3131 is laterally etched to form a hollow region, where the remaining third initial dielectric layer 3131 forms the third dielectric layer 313.

In the step of S33, referring to FIG. 12, the second conductive layer 312 is formed in the hollow region.

In the step of S31, referring to FIG. 10, the third initial dielectric layer 3131 may be disposed opposite to the first conductive layer 220, and the third initial dielectric layer and first conductive layer may have the same thickness. The second dielectric layer 311 may be disposed opposite to the first dielectric layer 210, and the second dielectric layer and the first dielectric layer may have the same thickness.

In an example, the step of S31 may include the steps as follows.

In the step of S311, a second dielectric material layer and a third dielectric material layer that are alternately stacked are formed on the base 100.

In the step of S312, the second dielectric material layer and the third dielectric material layer are etched to form the initial staircase structure 3001, where the third dielectric material layer remaining after etching forms the third initial dielectric layer 3131, and the second dielectric material layer remaining after etching forms the second dielectric layer 311.

In the step of S311, the second dielectric material layer and the third dielectric material layer that are alternately stacked may be sequentially formed on the base 100 with a deposition process.

In an example, the material of the second dielectric material layer includes silicon oxide, and the material of the third dielectric material layer includes silicon nitride.

In the step of S312, the second dielectric material layer and the third dielectric material layer may be etched in a manner such as a cyclic restrictive photoresist, to form the initial staircase structure 3001.

In an example, the initial staircase structure 3001 may include two groups of multiple stairs symmetrically disposed in the second direction.

In the step of S32, referring to FIG. 10 and FIG. 11, wet etching may be performed on the third initial dielectric layer 3131 to laterally etch the third initial dielectric layer 3131, to form the hollow region.

When the initial staircase structure 3001 can include two groups of multiple stairs symmetrically disposed in the second direction, both sides of the third initial dielectric layer 3131 in the second direction may be laterally etched to form symmetrical hollow regions.

In the step of S33, referring to FIG. 12, the second conductive layer 312 may be formed in the hollow region with a process such as electroplating or chemical vapor deposition.

When symmetrical hollow regions are formed, symmetrical second conductive layers 312 may be formed on the two sides of the third dielectric layer 313 in the second direction.

In this embodiment, the hollow region is formed through lateral etching, and then the second conductive layer 312 is formed in the hollow region. Currently, a lateral etching technology is mature and controllable, and orthographic projection areas of different second conductive layers 312 in different stair layer groups 310 may be effectively controlled to be the same on the base 100, so that an RC delay can be effectively reduced. In addition, in this case, the stair of the semiconductor structure may be manufactured monolithically, thereby reducing wafer processing costs.

In an embodiment, after the step of S30, the method further includes the steps as follows.

In the step of S40, multiple contact holes 10 respectively running through the multiple stairs are formed, referring to FIG. 13.

In the step of S50, a conductive plug 400 is formed in the contact hole 10, and the conductive plug 400 on each stair is connected to the second conductive layer 312 corresponding to the stair, referring to FIG. 14.

In the step of S40, the multiple contact holes 10 may run through the second conductive layers 312 corresponding to the stairs. The second conductive layers 312 may be completely staggered to form the contact holes 10 mutually spaced apart. Certainly, the second conductive layers 312 may alternatively be partially staggered.

In the step of S50, a plug material layer may be first deposited, and then chemical mechanical polishing (CMP) processing is performed on the plug material layer to form the conductive plugs 400.

The conductive plugs 400 may extend into a peripheral circuit structure located in the base 100, so that the conductive plugs 400 are electrically connected to the peripheral circuit structure. Alternatively, after the conductive plugs 400 are formed, a peripheral circuit structure may be formed on the top of the conductive plugs 400, so that the conductive plugs 400 are electrically connected to the peripheral circuit structure.

The material of the conductive plug 400 may include but is not limited to cobalt (Co), nickel (Ni), titanium (Ti), tungsten (W), tantalum (Ta), tantalum titanium (TaTi), tungsten nitride (WN), copper (Cu), aluminum (Al), and the like. The material of the conductive plug 400 may be the same as or different from the material of the second conductive layer 312.

In an example, when symmetrical second conductive layers 312 are formed on the two sides of the third dielectric layer 313 in the second direction, the staircase structure 300 may include two groups of multiple stairs symmetrically disposed in the second direction. It is set that one group of multiple stairs is located in the first staircase region A1, the other group of multiple stairs is located in the second staircase region A3, and a region between the first staircase region and the second staircase region is the non-staircase region A2.

In this case, the contact hole 10 running through an odd-numbered stair may be located in the first staircase region A1, and the contact hole 10 running through an even-numbered stair may be located in the second staircase region A3. Therefore, density of the contact holes 10 may be effectively reduced to reduce density of the subsequently formed conductive plugs 400, thereby preventing a short circuit between the conductive plugs 400.

In an example, the second region A5 forming the staircase structure 300 may be located on each of two sides of the first region A4 forming the patterned stacked structure 200, so that the staircase structure 300 is located on each of two sides of the patterned stacked structure 200 in the first direction.

In this case, the first conductive line 222 formed in the first region A4 may be led out from the second conductive layers 312 located on two sides of the first conductive line in the first direction, thereby improving flexibility of disposing the contact holes 10 and the conductive plugs 400 at the second conductive layers 312, and reducing density of disposing the contact holes and the conductive plugs.

In addition, in an example, in the step of S40, multiple conductive line holes 20 running through the patterned stacked structure 200 may be further formed while the multiple contact holes 10 respectively running through the multiple stairs are formed. In the step of S50, a second conductive line (not shown in the figure) may be further formed in the conductive line hole 20 while the conductive plug 400 is formed in the contact hole 10. One of the second conductive line and the first conductive line 222 is a bit line, and the other is a word line.

It should be understood that, although the steps in the flowchart of FIG. 4 are sequentially displayed according to indications of the arrows, these steps are not necessarily sequentially performed in the order indicated by the arrows. Unless expressly stated in this specification, these steps are not performed in a strict order, and these steps may be performed in another order. In addition, at least some steps in FIG. 4 may include multiple stairs or multiple phases. These steps or phases are not necessarily performed and completed at the same moment, but may be performed at different moments. These steps or phases are not necessarily performed sequentially, but may be performed in turn or alternately with another step or at least some of the steps or phases in the another step.

The technical features in the foregoing embodiments may be combined arbitrarily. For brevity of description, not all possible combinations of these technical features in the foregoing embodiments are described. However, as long as these combinations of technical features are not contradictory, they should all be considered within the scope described in the specification.

The foregoing embodiments represent only several implementations of the present disclosure, and descriptions thereof are relatively specific and detailed, but should not be construed as limitations on the patent scope of this application. It should be noted that, a person of ordinary skill in the art can further make several variations and improvements without departing from the concept of the present disclosure, all of which shall fall within the protection scope of the present disclosure. Therefore, the patent protection scope of the present disclosure shall be subject to the appended claims.

## Claims

1. A semiconductor structure, comprising:
a base (100);
a patterned stacked structure (200) located on the base (100), comprising a first dielectric layer (210) and a first conductive layer (220) that are alternately stacked and whose orthographic projections on the base (100) overlap each other, the first conductive layer (220) comprising a line connection portion (221) and a first conductive line (222), and the first conductive line (222) being connected to the line connection portion (221) in a first direction; and
a staircase structure (300) located on the base (100) and located on a side that is of the line connection portion (221) and that is away from the first conductive line (222) in the first direction, comprising a plurality of stair layer groups (310) that are stacked, the plurality of stair layer groups (310) forming a plurality of stairs distributed in a second direction, each of the stair layer groups (310) comprising a second dielectric layer (311), a second conductive layer (312), and a third dielectric layer (313), the second conductive layer (312) being connected to the line connection portion (221) in the first direction, in a same one of the stair layer groups (310), the third dielectric layer (313) and the second conductive layer (312) being arranged in the second direction and orthographic projections of the third dielectric layer and the second conductive layer on the base (100) overlapping an orthographic projection of the second dielectric layer (311) on the base (100), the plurality of second conductive layers (312) in the plurality of stair layer groups (310) having a same orthographic projection area on the base (100), and the second direction intersecting the first direction.

2. The semiconductor structure according to claim 1, wherein in a same one of the stair layer groups (310), the second dielectric layer (311) is away from the base (100) relative to the second conductive layer (312) and the third dielectric layer (313).

3. The semiconductor structure according to claim 1, wherein the staircase structure (300) has a first staircase region (A1), a non-staircase region (A2), and a second staircase region (A3), the first staircase region (A1) and the second staircase region (A3) are located on two sides of the non-staircase region (A2) in the second direction, the plurality of stair layer groups (310) form the plurality of stairs in both the first staircase region (A1) and the second staircase region (A3), and in a same one of the stair layer groups (310), the second conductive layer (312) is disposed in the first staircase region (A1) and/or the second staircase region (A3).

4. The semiconductor structure according to claim 3, wherein in a same one of the stair layer groups (310), the second conductive layer (312) is located on each of two sides of the third dielectric layer (313) in the second direction.

5. The semiconductor structure according to claim 3, wherein in a same one of the stair layer groups (310), the second conductive layer (312) is located only on one side of the third dielectric layer (313) in the second direction, and in a direction perpendicular to the base (100), the second conductive layers (312) in neighboring stair layer groups (310) are located on two opposite sides in the second direction.

6. The semiconductor structure according to claim 3, wherein the semiconductor structure further comprises a plurality of conductive plugs (400), the plurality of conductive plugs (400) respectively run through the plurality of stairs to be connected to the corresponding second conductive layers (312), each of the conductive plugs (400) that runs through an odd-numbered stair is located in the first staircase region (A1), and each of the conductive plugs (400) that runs through an even-numbered stair is located in the second staircase region (A3).

7. The semiconductor structure according to any one of claims 1 to 6, wherein the plurality of second conductive layers (312) in the plurality of stair layer groups (310) are completely staggered sequentially in the second direction.

8. The semiconductor structure according to any one of claims 1 to 6, wherein the plurality of second conductive layers (312) in the plurality of stair layer groups (310) are partially staggered sequentially in the second direction.

9. The semiconductor structure according to any one of claims 1 to 6, wherein the line connection portion (221) is disposed on each of both sides of the first conductive line (222) in the first direction, and the staircase structure (300) is disposed on each of both sides of the patterned stacked structure (200) in the first direction.

10. A manufacturing method for a semiconductor structure, comprising:
providing a base (100);
forming a patterned stacked structure (200) on the base (100), the patterned stacked structure (200) comprising a first dielectric layer (210) and a first conductive layer (220) that are alternately stacked and whose orthographic projections on the base (100) overlap each other, the first conductive layer (220) comprising a line connection portion (221) and a first conductive line (222), and the first conductive line (222) being connected to the line connection portion (221) in a first direction; and
forming a staircase structure (300) on the base (100) on a side that is of the line connection portion (221) and that is away from the first conductive line (222) in the first direction, the staircase structure (300) comprising a plurality of stair layer groups (310) that are stacked, the plurality of stair layer groups (310) forming a plurality of stairs distributed in a second direction, each of the stair layer groups (310) comprising a second dielectric layer (311), a second conductive layer (312), and a third dielectric layer (313), the second conductive layer (312) being connected to the line connection portion (221) in the first direction, in a same one of the stair layer groups (310), the third dielectric layer (313) and the second conductive layer (312) being arranged in the second direction and orthographic projections of the third dielectric layer and the second conductive layer on the base (100) overlapping an orthographic projection of the second dielectric layer (311) on the base (100), the plurality of second conductive layers (312) in the plurality of stair layer groups (310) having a same orthographic projection area on the base (100), and the second direction intersecting the first direction.

11. The manufacturing method for a semiconductor structure according to claim 10, wherein the forming a patterned stacked structure (200) on the base (100) comprises:
forming a first dielectric material layer and a sacrificial material layer on the base (100) that are alternately stacked;
performing patterning processing on the first dielectric material layer and the sacrificial material layer, the remaining first dielectric material layer forming the first dielectric layer (210), and the remaining sacrificial material layer forming a sacrificial layer; and
removing the sacrificial layer, and forming the first conductive layer (220) in a region from which the sacrificial layer is removed.

12. The manufacturing method for a semiconductor structure according to claim 11, wherein a material of the first dielectric material layer comprises silicon oxide, and a material of the sacrificial material layer comprises silicon nitride.

13. The manufacturing method for a semiconductor structure according to claim 10, wherein the forming a staircase structure (300) on the base (100) on a side that is of the line connection portion (221) and that is away from the first conductive line (222) in the first direction comprises:
forming an initial staircase structure (3001) on the base (100) on the side that is of the line connection portion (221) and that is away from the first conductive line (222) in the first direction, the initial staircase structure (3001) comprising a plurality of initial stair layer groups (3101) that are stacked, widths of the plurality of initial stair layer groups (3101) in the second direction sequentially decreasing with a stacking height to form a plurality of stairs distributed in the second direction, each of the initial stair layer groups (3101) comprising a third initial dielectric layer (3131) and the second dielectric layer (311) formed sequentially, and in a same one of the initial stair layer groups (3101), an orthographic projection of the third initial dielectric layer (3131) on the base (100) overlapping an orthographic projection of the second dielectric layer (311) on the base (100);
laterally etching the third initial dielectric layer (3131) to form a hollow region, the remaining third initial dielectric layer (3131) forming the third dielectric layer (313); and
forming the second conductive layer (312) in the hollow region.

14. The manufacturing method for a semiconductor structure according to claim 13, wherein the forming an initial staircase structure (3001) on the base (100) on the side that is of the line connection portion (221) and that is away from the first conductive line (222) in the first direction comprises:
forming a second dielectric material layer and a third dielectric material layer on the base (100) that are alternately stacked; and
etching the second dielectric material layer and the third dielectric material layer to form the initial staircase structure (3001), the third dielectric material layer remaining after etching forming the third initial dielectric layer (3131), and the second dielectric material layer remaining after etching forming the second dielectric layer (311).

15. The manufacturing method for a semiconductor structure according to claim 10, after the forming a staircase structure (300) on the base (100) on a side that is of the line connection portion (221) and that is away from the first conductive line (222) in the first direction, further comprising:
forming a plurality of contact holes (10) respectively running through the plurality of stairs; and
forming a conductive plug (400) in each of the contact holes (10), the conductive plug (400) on each of the stairs being connected to the second conductive layer (312) corresponding to the stair.

16. The manufacturing method for a semiconductor structure according to claim 15, wherein the staircase structure (300) has a first staircase region (A1), a non-staircase region (A2), and a second staircase region (A3), the first staircase region (A1) and the second staircase region (A3) are located on two sides of the non-staircase region (A2) in the second direction, the plurality of stair layer groups (310) form the plurality of stairs in both the first staircase region (A1) and the second staircase region (A3), and in a same one of the stair layer groups (310), the second conductive layer (312) is disposed in the first staircase region (A1) and/or the second staircase region (A3).

17. The manufacturing method for a semiconductor structure according to claim 16, wherein the conductive plugs (400) respectively run through the plurality of stairs to be connected to the corresponding second conductive layers (312), each of the conductive plugs (400) that runs through an odd-numbered stair is located in the first staircase region (A1), and each of the conductive plugs (400) that runs through an even-numbered stair is located in the second staircase region (A3).

18. The manufacturing method for a semiconductor structure according to any one of claims 10 to 17, wherein the plurality of second conductive layers (312) in the plurality of stair layer groups (310) are completely staggered sequentially in the second direction.

19. The manufacturing method for a semiconductor structure according to any one of claims 10 to 17, wherein the plurality of second conductive layers (312) in the plurality of stair layer groups (310) are partially staggered sequentially in the second direction.

20. The manufacturing method for a semiconductor structure according to any one of claims 10 to 17, wherein the line connection portion (221) is disposed on each of both sides of the first conductive line (222) in the first direction, and the staircase structure (300) is disposed on each of both sides of the patterned stacked structure (200) in the first direction.
